# EUROPEAN PATENT APPLICATION

(11) **EP 2 063 691 A2**
(43) Date of publication of application: **27.05.2009**
(21) Application number: 08253818.2
(22) Date of filing: 26.11.2008
(51) Int. Cl.: H05K 1/14, H05K 3/36

(54) **Plasma display device**

(30) Priority: 26.11.2007 KR 20070120983
(71) Applicant: Samsung SDI Co., Ltd., Suwon-si, Gyeonggi-do (KR)
(72) Inventor: Jeong, Kwang-Jin, Suwon-si Gyeonggi-do (KR)
(74) Representative: Mounteney, Simon James

(57) **Abstract**

A plasma display device is disclosed. In one embodiment, the plasma display device includes a plasma display panel (11), a chassis base (15), a printed circuit board assembly (17), and a flexible printed circuit (27). The chassis base supports the plasma display panel. The printed circuit board assembly is disposed at one side of the chassis base. The flexible printed circuit electrically connects an electrode of the plasma display panel and the printed circuit board assembly. The flexible printed circuit crosses an extension plane of the printed circuit board assembly at a predetermined angle and is connected to the printed circuit board assembly. One embodiment of the invention lowers manufacturing costs and reduces EMI by shortening a length of a flexible printed circuit.

## Description

### BACKGROUND OF THE INVENTION

### (a) Field of the Invention

The present invention relates to a plasma display device. More particularly, the present invention relates to a plasma display panel for lowering manufacturing costs and reducing electromagnetic interference (EMI) by shortening a length of a flexible printed circuit that connects a printed circuit board assembly and a plasma display panel.

### (b) Description of the Related Technology

As is known, a plasma display device displays an image on a plasma display panel. The plasma display panel includes electrodes, for example, display electrodes and address electrodes, which are electrically connected to a printed circuit board assembly through a flexible printed circuit.

In more detail, the flexible printed circuit includes one end connected to an electrode by, for example, using an anisotropic conductive film (ACF) and the other end connected to a printed circuit board assembly through a connector.

The plasma display panel and a chassis base are arranged substantially in parallel and adhered to each other. Also, a printed circuit board assembly is disposed at the chassis base substantially in parallel with the chassis base.

When one end of a flexible printed circuit is adhered to an electrode of a plasma display panel, the flexible printed circuit is hung down in a length direction of the electrode from the plasma display panel. Then, if the other end of the flexible printed circuit is connected to a connector of a printed circuit board assembly, the flexible printed circuit is bent at about 180° from one end of a chassis base.

That is, since the flexible printed circuit connects an electrode of a plasma display panel and a printed circuit board assembly as a connector, both ends of the flexible printed circuit extend toward the same direction substantially in parallel with each other. For example, the flexible printed circuit is formed in generally a "U" shape.

The flexible printed circuit is a substrate made from a heat resistant plastic film such as polyester (PET) and polyimide (PI). The longer the flexible printed circuit is, the higher the manufacturing cost is and the more EMI is generated.

If the length of the flexible printed circuit is extended, it is generally desirable to have supplementary constituent elements to shield EMI.

The above information disclosed in this Background section is only for enhancement of understanding of the background of the invention and therefore it may contain information that does not form the prior art that is already known in this jurisdiction to a person of ordinary skill in the art.

### SUMMARY OF CERTAIN INVENTIVE ASPECTS

The present invention sets out to provide a plasma display device having advantages of lowering manufacturing costs and reducing EMI by shortening a length of a flexible printed circuit.

A first aspect of the present invention provides a plasma display device including a plasma display panel, a chassis base, a printed circuit board assembly, and a flexible printed circuit. The chassis base supports the plasma display panel, the printed circuit board assembly is disposed at one side of the chassis base, and the flexible printed circuit electrically connects an electrode of the plasma display panel and the printed circuit board assembly. The flexible printed circuit crosses an extension plane of the printed circuit board assembly at a predetermined angle and is connected to the printed circuit board assembly.

The flexible printed circuit may include a first end connected to the electrode and a second end connected to the printed circuit board assembly. The first end may face a direction identical to an elongated direction of the electrode, and the second end may face a direction crossing an extension plane of the printed circuit board assembly.

The electrode may include an address electrode, and the printed circuit board assembly may include an address buffer board. In the flexible printed circuit, the first end may face a direction identical to a length direction of the address electrode, and the second end may face a direction crossing an extension plane of the address buffer board.

The chassis base may include a bent portion that is bent toward the plasma display panel, and the flexible printed circuit may include a driver integrated circuit for controlling the address electrode. The driver integrated circuit may be disposed to correspond to the bent portion.

The flexible printed circuit may further include a cover plate disposed in parallel with the bent portion and covering the driver integrated circuit.

The plasma display device may further include a heat dissipation pad disposed between the flexible printed circuit and the bent portion, and a thermal grease disposed between the driver integrated circuit and the cover plate.

In the flexible printed circuit, a first extension line extended from the first end may perpendicularly cross a second extension line extended from the second end.

The plasma display device may further include a connector interposed between the printed circuit board assembly and the flexible printed circuit.

The connector may include a first connection hole connected to a first terminal formed at the flexible printed circuit, and a second connection hole connected to a second terminal formed at the printed circuit board assembly.

The first and second connection holes may be electrically connected to each other and face in directions crossing each other.

The flexible printed circuit may be connected in a direction perpendicularly crossing an extension plane of the printed circuit board assembly.

Another aspect of the present invention provides a plasma display device including a plasma display panel, a chassis base, an address buffer board, a flexible printed circuit, and a connector. The chassis base supports the plasma display panel, the address buffer board is disposed at one side of the chassis base, and the flexible printed circuit is connected to an address electrode of the plasma display panel in a length direction of the address electrode. The connector connects the flexible printed circuit and the address buffer board. The connector is connected to an end of the address buffer board, and the flexible printed circuit is connected to the connector in a direction crossing an extension plane of the address buffer board at a predetermined angle.

The connector may include a first connection hole connected to a first terminal formed at the flexible printed circuit, and a second connection hole connected to a second terminal formed at the address buffer board.

The first and second connection holes may be perpendicularly disposed.

The flexible printed circuit may be formed as a tape carrier package that includes a driver integrated circuit for controlling the address electrode.

The chassis base may include a bent portion that is bent toward the plasma display panel, and a width of the bent portion may be larger than a width of the driver integrated circuit and smaller than half of a thickness of the plasma display panel.

Another aspect of the invention provides a plasma display device comprising: i) a plasma display panel, ii) a chassis base configured to support the plasma display panel, iii) a printed circuit board assembly disposed at one side of the chassis base and iv) a flexible printed circuit configured to electrically connect an electrode of the plasma display panel and the printed circuit board assembly, wherein the flexible printed circuit is bent only once.

In the plasma display device, the flexible printed circuit may comprise: a first end connected to the electrode and a second end connected to the printed circuit board assembly, wherein the first end is generally parallel to the electrode, and the second end crosses an extension plane of the printed circuit board assembly.

In the plasma display device, the electrode may comprise an address electrode, the printed circuit board assembly comprises an address buffer board, the first end is generally parallel to the address electrode, and the second end crosses an extension plane of the address buffer board.

In the plasma display device, the chassis base may comprise a bent portion that is bent toward the plasma display panel, the flexible printed circuit comprises a driver integrated circuit disposed to correspond to the bent potion and configured to control the address electrode.

The plasma display device may further comprise a cover plate disposed in substantially parallel with the bent portion and covering the driver integrated circuit. The plasma display device may further comprise: a heat dissipation pad disposed between the flexible printed circuit and the bent portion and a thermal grease disposed between the driver integrated circuit and the cover plate.

In the plasma display device, the first end may be generally perpendicular to the second end. The plasma display device may further comprise a connector interposed between the printed circuit board assembly and the flexible printed circuit.

In the plasma display device, first and second connection holes may be defined in the connector, and wherein: the first connection hole is configured to receive a first terminal formed at the flexible printed circuit and the second connection hole is configured to receive a second terminal formed at the printed circuit board assembly. In the plasma display device, the first and second connection holes may be electrically connected to each other and face in directions crossing each other.

In the plasma display device, the flexible printed circuit may comprise first and second portions, wherein the first portion may be generally parallel to the printed circuit board assembly, and wherein the second portion crosses an extension plane of the printed circuit board assembly.

Another aspect of the invention provides a plasma display device comprising: i) a plasma display panel, ii) a chassis base configured to support the plasma display panel, iii) an address buffer board disposed at one side of the chassis base, iv) a flexible printed circuit comprising two ends, wherein one end is generally parallel with an address electrode of the plasma display panel and v) a connector configured to electrically connect the other end of the flexible printed circuit and the address buffer board such that the other end crosses an extension plane of the address buffer board.

In the plasma display device, first and second connection holes may be defined in the connector, and wherein: the first connection hole is configured to receive a first terminal formed at the other end of the flexible printed circuit and the second connection hole is configured to receive a second terminal formed at the address buffer board.

In the plasma display device, the first and second connection holes may be generally perpendicular to each other. In the plasma display device, the flexible printed circuit may be integrated into a tape carrier package that comprises a driver integrated circuit configured to control the address electrode.

In the plasma display device, the chassis base may comprise a bent portion that is bent toward the plasma display panel, and the width of the bent portion may be larger than the width of the driver integrated circuit and smaller than about half the thickness of the plasma display panel.

The plasma display device may further comprise: a heat dissipation pad disposed between a first surface of the flexible printed circuit and the bent portion, wherein the driver integrated circuit is formed on a second surface of the flexible printed circuit, and wherein the second surface is opposing the first surface. In the plasma display device, the heat dissipation pad and the driver integrated circuit may be substantially symmetrically positioned with respect to the flexible printed circuit.

Still another aspect of the invention provides a plasma display device comprising: i) a plasma display panel, ii) a chassis base configured to support the plasma display panel, iii) a circuit board assembly disposed at one side of the chassis base and iv) a flexible printed circuit configured to electrically connect an electrode of the plasma display panel and the circuit board assembly, wherein the flexible printed circuit comprises first and second ends, wherein only the first end is generally parallel with at least one of the electrode and circuit board assembly.

The plasma display device may further comprise a connector configured to electrically connect the second end of the flexible printed circuit and an electrical terminal of the circuit board assembly such that the second end is generally perpendicular to the circuit board assembly.

The above and other features of the invention are set out in the appended claims.

### BRIEF DESCRIPTION OF THE DRAWINGS

FIG. 1 is an exploded perspective view of a plasma display device according to an embodiment of the present invention.
FIG. 2 is a cross-sectional view of FIG. 1 taken along the line II-II .
FIG. 3 is a partial perspective view of a flexible printed circuit of FIG. 2.
FIG. 4 is a perspective view of a connector.

### DETAILED DESCRIPTION OF CERTAIN INVENTIVE EMBODIMENTS

Embodiments of the present invention will be described more fully hereinafter with reference to the accompanying drawings, in which embodiments of the invention are shown. As those skilled in the art would realize, the described embodiments may be modified in various different ways, all without departing from the scope of the present invention. The drawings and description are to be regarded as illustrative in nature and not restrictive. Like reference numerals designate like elements throughout the specification.

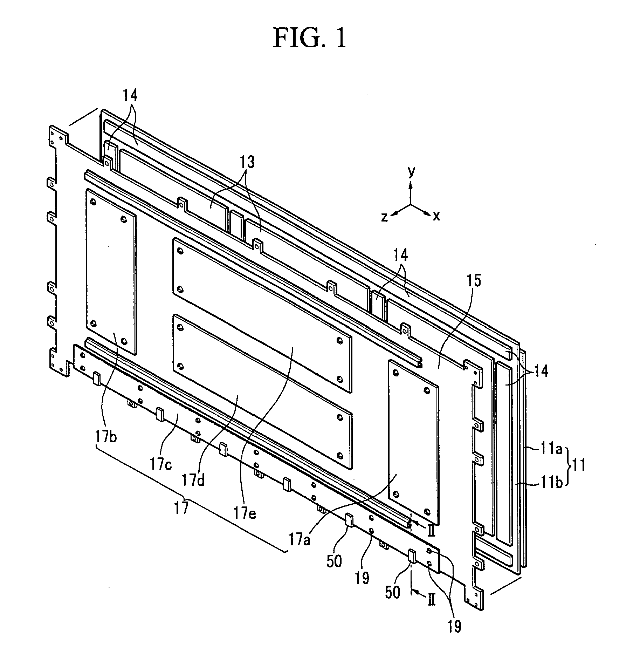

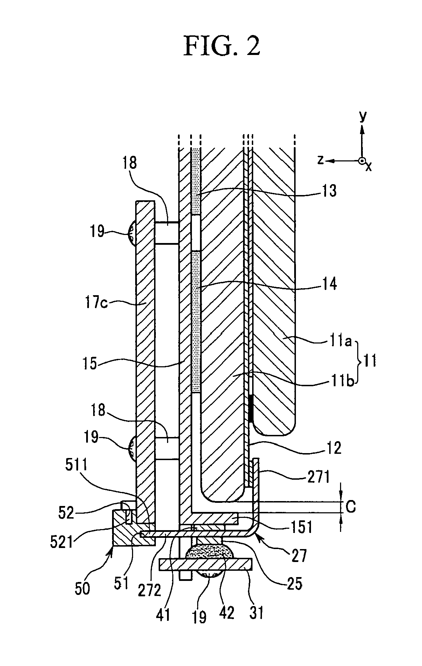

FIG. 1 is an exploded perspective view of a plasma display device according to an embodiment of the present invention, and FIG. 2 is a cross-sectional view of FIG. 1 taken along the line II-II .

Referring to FIG. 1 and FIG. 2, the plasma display device includes a plasma display panel (PDP) 11, heat dissipation sheets 13, a chassis base 15, and a printed circuit board assembly 17.

The PDP 11 includes a front substrate 11 a and a rear substrate 11 b, and displays an image using gas discharge. The PDP 11 has a general structure and function that are widely known.

This embodiment of the present invention relates to connection of additional constituent elements that support the PDP 11 rather than to the PDP 11 itself. Therefore, detail descriptions of general constituent elements of the PDP 11 are omitted.

The heat dissipation sheets 13 are disposed at a rear side of the PDP 11. The heat dissipation sheets 13 quickly dissipate locally generated internal heat, thereby realizing thermal equilibrium on an entire surface of the PDP 11.

As examples, the heat dissipation sheets 13 may be made of an acryl-based heat dissipation material, a graphite group heat dissipation material, a metal group heat dissipation material, or a carbon nanotube group heat dissipation material.

Referring to FIG. 2, the chassis base 15 is adhered to a rear surface of the PDP 11 with a double-sided adhesive tape 14 interposed therebetween, thereby supporting the PDP 11. As an example, the chassis base 15 overlaps a rear surface of the PDP 11 and includes a bent portion 151 disposed at a lower part of the chassis base 15, which is bent toward the PDP 11.

In more detail, the bent portion 151 is bent toward the rear substrate 11b from a rear of the PDP 11, and the bent portion 151 reaches a position lower than a bottom end of the rear substrate 11b, referring to FIG. 2. Therefore, the bent portion 151 is separated from the rear substrate 11b by a predetermined gap C (See Figure 2).

Since the chassis base 15 is generally made of a metal, the bent portion 151 that is bent from the chassis base 15 is also made of a metal. The rear substrate 11 b is generally made of a different material from that of the bent portion 151, for example of glass.

The bent portion 151 may be deformed temporally by an external force such as an assembly impact. That is, the gap C provides a buffer space when the bent portion 151 is bent toward the rear substrate 11b. Therefore, the deformation of the bent portion 151 may prevent the rear substrate 11b from being broken.

Referring to FIG. 1 again, the printed circuit board assembly 17 is disposed at a rear side of the chassis base 15 and electrically connected to electrodes of the PDP 11. In FIG. 2, an address electrode 12 is shown and a display electrode is omitted.

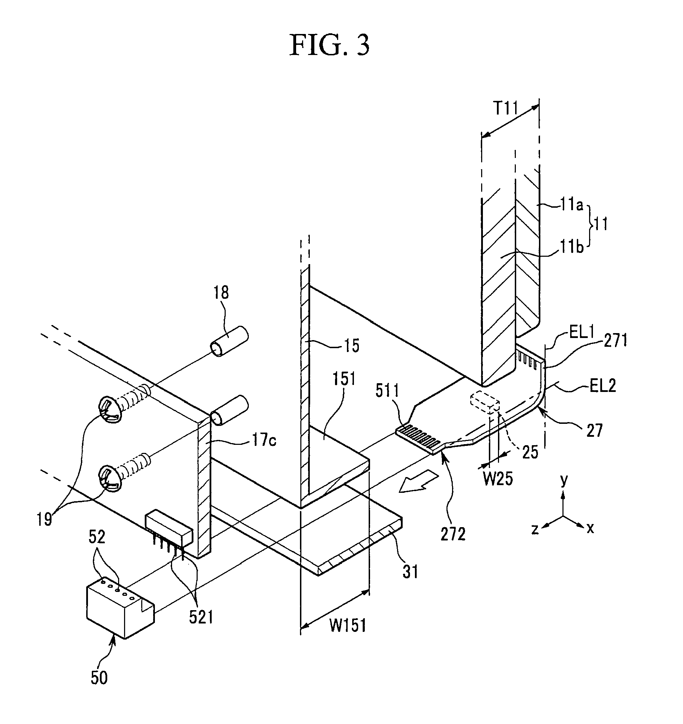

The printed circuit board assemblies 17 are seated on a plurality of bosses 18 disposed in the chassis base 15 (see 18 in FIG. 2 and FIG. 3). The printed circuit board assemblies 17 are joined to the bosses 18 through setscrews 19.

The printed circuit board assemblies 17 includes i) a sustain electrode driving board 17a for controlling a sustain electrode (not shown) among display electrodes, ii) a scan electrode driving board 17b for controlling a scan electrode (not shown) among display electrodes, and iii) an address buffer board 17c for controlling an address electrode 12.

The printed circuit board assemblies 17 further include a logic board 17d and a power supply board 17e. The logic board 17d receives a video signal from an external device, generates control signals for driving the address electrode 12, the sustain electrode, and the scan electrode, and applies the generated control signals to corresponding printed circuit board assemblies. The power supply board 17e supplies power necessary to drive the printed circuit board assemblies 17.

The sustain electrode driving board 17a is a flexible printed circuit and is connected to a sustain electrode. The scan electrode driving board 17b is a flexible printed circuit and is connected to a scan electrode (not shown). The address buffer board 17c is a flexible printed circuit 27 and is connected to the address electrode 12 (see FIG. 2).

The embodiment of the present invention may be applied to all of the connection structure of the sustain electrode and the sustain electrode driving board 17a, the connection structure of the scan electrode and the scan electrode driving board 17b, and the connection structure of the address electrode 12 and the address buffer board 17c.

For convenience, the connection structure of the address electrode 12 and the address buffer board 17c will be described, and descriptions of the connection structure of the sustain electrode and the sustain electrode driving board 17a and the connection structure of the scan electrode and the scan electrode driving board 17b are omitted.

The address electrode 12 is connected to the address buffer board 17c through the flexible printed circuit 27 having a driver integrated circuit 25. That is, the flexible printed circuit 27 connected to the address electrode 12 further includes the driver integrated circuit 25, unlike a flexible printed circuit (not shown) connected to a sustain electrode or a scan electrode.

Hereinafter, the flexible printed circuit 27 connecting the address electrode 12 and the address buffer board 17c, the driver integrated circuit 25, and peripheral devices thereof will be described in detail.

The flexible printed circuit 27 includes the driver integrated circuit 25 for generating a control signal of the address electrode 12 and may be formed in a tape carrier package (TCP), for example.

The flexible printed circuit 27 is connected to the address electrode 12 and the address buffer board 17c while being bent. In one embodiment, a connection length thereof is shortened by minimally bending the flexible printed circuit 27. Therefore, the manufacturing costs are lowered and EMI is reduced compared to a typical PDP device having a "U" shape flexible printed circuit.

As an example, the flexible printed circuit 27 is connected to the address buffer board 17c and crosses a plane extended from the address buffer board 17c at a predetermined angle which is greater than 0 degree. In the typical PDP device, the flexible printed circuit is "U" shaped and a bent portion of the flexible printed circuit is connected to the address buffer board such that the bent portion extends substantially in parallel with a length direction of the address buffer board 17c.

FIG. 3 is a partial perspective view of a flexible printed circuit of FIG. 2.

Referring to FIG. 3, the flexible printed circuit 27 includes a first end 271 and a second end 272. The first end 271 is connected to the address electrode 11, and the second end 272 is connected to the address buffer board 17c.

Also, the first end 271 of the flexible printed circuit 27 is connected to the address electrode 11 to face substantially the same direction of an elongated direction (y-axis direction) of the address electrode 11.

The second end 272 of the flexible printed circuit 27 is connected to the address buffer board 17c to face a direction (Z-axis direction) crossing a virtual plane (x-y plane) extended from the address buffer board 17c.

The bent flexible printed circuit 27 includes a first extension line EL1 virtually extended in substantially the same direction (y-axis direction) as the first end 271, and a second extension line EL2 virtually extended in substantially the same direction (Z-axis direction) as the second end 272.

When the flexible printed circuit 27 is connected to the address electrode 11 and the address buffer board 17c, the first extension line EL1 extended from the first end 271 crosses the second extension line EL2 extended from the second end 272.

Since the second end 272 of the flexible printed circuit 27 is connected in a direction crossing an extension plane (x-y plane) of the address buffer board 17c, the flexible printed circuit 27 is less bent than that of the typical PDP device. Accordingly, the length of the flexible printed circuit 27 is shortened.

Referring to FIG. 2, when the second end 272 and the address buffer board 17c cross each other substantially perpendicularly, the length of the flexible printed circuit 27 becomes the shortest. Here, although the flexible printed circuit 27 is bent in a curved line at the middle, the first extension line EL1 and the second extension line EL2 substantially perpendicularly cross each other.

The structure for shortening the length of the flexible printed circuit 27 may be formed in various ways. For example, the second end 272 of the flexible printed circuit 27 may be directly adhered or joined to the address buffer board 17c, without using a connector, although this is not shown in the accompanying drawings. In this embodiment, 1) a second terminal 521 of the address buffer board 17c and/or 2) the first terminal of the flexible printed circuit 27 may be modified for suitable electrical interconnection.

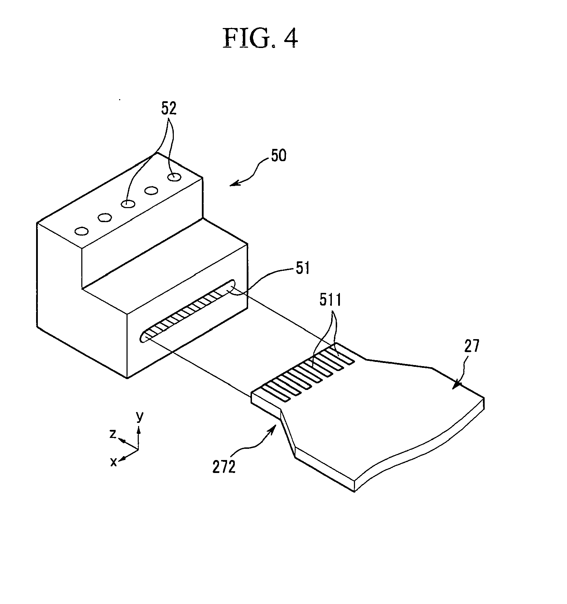

FIG. 4 is a perspective view of a connector.

FIG. 4 shows that a connector 50 shortens the length of the flexible printed circuit 27 compared to the typical PDP device.

The connector 50 is interposed between the address buffer board 17c and the flexible printed circuit 27. That is, the connector 50 connects the second end 272 of the flexible printed circuit 27 in a direction (z-axis direction) crossing a plane (x-y plane) virtually extended from the address buffer board 17c.

As an example, the connector 50 includes a first connecting hole 51 and second connecting holes 52 that are electrically connected to each other and formed in directions crossing each other.

The first connection hole 51 is connected to a second connecting holes 511 formed at the second end 272 of the flexible printed circuit 27, and the second connection hole 52 is connected to a second terminal 521 formed at the address buffer board 17c.

By forming the first connection hole 51 and the second connection holes 52 to cross each other, an extension plane (x-y plane) of the address buffer board 17c and the second extension line EL2 (z-axis direction) of the second end 272 of the flexible printed circuit 27 that are connected to the first and second connection holes 51 and 52 cross each other.

By forming the first connection hole 51 and the second connection holes 52 to substantially perpendicularly cross each other as shown in FIG. 2 to FIG. 4, an extension plane (x-y plane) of the address buffer board 17c and the second extension line EL2 (z-axis direction) of the second end 272 of the flexible printed circuit 27 that are connected to the first and second connection holes 51 and 52 substantially perpendicularly cross each other.

Therefore, although the flexible printed circuit 27 is bent at the first end 271 once, the flexible printed circuit 27 is not bent at the second end 272. Finally, the length of the flexible printed circuit 27 is shortened. Therefore, the manufacturing cost thereof is lowered and EMI is reduced.

Meanwhile, since the flexible printed circuit 27 includes the driver integrated circuit 25, it is possible to design a structure for protecting the driver integrated circuit 25 and radiating heat while shortening the length of the flexible printed circuit 27.

That is, the bent portion 151 of the chassis base 15 has a predetermined width (W151) for supporting and protecting the flexible printed circuit 27 and the driver integrated circuit 25. The width W151 of the bent portion 151 is wider than the width (W25) of the driver integrated circuit 25 and is narrower than half of the thickness (T11) of the PDP 11. The wider the width (W151) of the bent portion 151 is, the greater the support of the driver integrated circuit 25 is.

Since internal thicknesses of both substrates are very small, being negligible compared to the thicknesses of the front substrate 11a and the rear substrate 11 b, the thickness (T11) of the PDP 11 may be considered to be substantially equal to the sum of thicknesses of the front substrate 11a and the rear substrate 11b.

Therefore, the width (W151) of the bent portion 151, which is smaller than about half of the thickness (T11) of the PDP 11, is a size that allows the bent portion 151 to not substantially protrude to the front surface of the rear substrate 11 b.

Finally, the width (W151), which is smaller than about half of the thickness (T11) of the PDP 11, prevents the flexible printed circuit 27 from being damaged by avoiding interference between the bent portion 151 and the flexible printed circuit 27 that is bent and surrounds the bent portion 151 (for convenience, when a heat dissipation sheet 13 is ignored in FIG. 2).

Since the bent portion 151 is bent toward the PDP 11 although the bent portion 151 supports the driver integrated circuit 25, it minimizes a bending path of the flexible printed circuit 27. Resultantly, the flexible printed circuit (FPC) 27 has a short length. Meanwhile, when the address buffer board 17c further extends to the bottom of the bent portion 151 of the chassis base 15, the flexible printed circuit 27 may be bent at an angle larger than the right angle (not shown).

When the first end 271 and the second end 272 of the flexible printed circuit 27 are connected to the address electrode 11 and the address buffer board 17c, the flexible printed circuit 27 is bent while surrounding the rear substrate 11 b and the bent portion 151. Here, the driver integrated circuit 25 in the flexible printed circuit 27 is disposed at a predetermined location corresponding to the bent portion 151.

A cover plate 31 may be applied to protect the driver integrated circuit 25 and to radiate heat. The cover plate 31 is disposed in parallel with the bent portion 151 of the chassis base 15 while covering the flexible printed circuit 27 and the driver integrated circuit 25. The cover plate 31 is mounted by a setscrew 19.

The flexible printed circuit 27 and the driver integrated circuit 25 are disposed between the bent portion 151 of the chassis base 15 and the cover plate 31. Therefore, a heat dissipation structure is applied between the bent portion 151 of the chassis base and the cover plate 31 for radiating heat when the driver integrated circuit 25 is driving.

For example, a heat dissipation pad 41 and a thermal grease 42 are provided at both sides of the driver integrated circuit 25 in order to radiate heat using the cover plate 31 and the bent portion 151, and the driver integrated circuit 25 is connected to the cover plate 31 and the bent portion 151.

The heat dissipation pad 41 is interposed between the driver integrated circuit 25 and the bent portion 151 and dissipates heat to the bent portion 151, and the thermal grease 42 is interposed between the driver integrated circuit 25 and the cover plate 31 and dissipates heat to the cover plate 31.

As described above, the flexible printed circuit connected to electrodes is connected to the printed circuit board assembly to cross an extension plane of the printed circuit board assembly and the flexible printed circuit at a predetermined angle in the plasma display device according to an embodiment of the present invention. Therefore, a length of the flexible printed circuit is shortened.

By shortening the length of the flexible printed circuit, the manufacturing cost thereof is lowered and less EMI is generated from around the flexible printed circuit. Also, additional constituent elements for an EMI shield are not necessary.

While this invention has been described in connection with what is presently considered to be practical embodiments, it is to be understood that the invention is not limited to the disclosed embodiments, but, on the contrary, is intended to cover various modifications and equivalent arrangements included within the scope of the appended claims.

## Claims

1. A plasma display device comprising:
a plasma display panel;
a chassis base configured to support the plasma display panel;
a circuit board assembly disposed at one side of the chassis base; and
a flexible printed circuit configured to electrically connect an electrode of the plasma display panel and the circuit board assembly,
wherein the flexible printed circuit comprises first and second end portions,
wherein only the first end portion is generally parallel with at least one of the electrode and circuit board assembly.

2. A plasma display device according to claim 1, wherein the first end portion is connected to the electrode and generally parallel therewith, and the second end portion is connected to the circuit board assembly and crosses an extension plane thereof.

3. A plasma display device according to claim 2, further comprising a connector interposed between the printed circuit board assembly and the flexible printed circuit.

4. A plasma display device of claim according to Claim 3, wherein the connector is configured to electrically connect the second end portion of the flexible printed circuit and an electrical terminal of the circuit board assembly such that the second end portion is generally perpendicular to the circuit board assembly.

5. A plasma display device according to Claim 3 or 4, wherein first and second connection holes are defined in the connector, and wherein:
the first connection hole is configured to receive a first terminal formed at the flexible printed circuit; and
the second connection hole is configured to receive a second terminal formed at the printed circuit board assembly.

6. A plasma display device according to claim 5, wherein the first and second connection holes are electrically connected to each other and face in directions generally perpendicular to each other.

7. A plasma display device according to any preceding claim, wherein the first end portion is generally perpendicular to the second end portion.

8. A plasma display device according to any preceding claim, wherein the flexible printed circuit comprises first and second body portions, wherein the first body portion is generally parallel to the printed circuit board assembly, and wherein the second body portion crosses an extension plane of the printed circuit board assembly.

9. A plasma display device according to any preceding claim, wherein the flexible printed circuit comprises a driver integrated circuit configured to control the electrode.

10. A plasma display device according to Claim 9, wherein the chassis base comprises a bent portion that is bent toward the plasma display panel and corresponds to the position of the driver integrated circuit.

11. A plasma display device according to Claim 10, wherein the width of the bent portion is larger than the width of the driver integrated circuit and less than half the thickness of the plasma display panel.

12. A plasma display device according to Claim 10 or 11, further comprising a cover plate disposed substantially parallel to the bent portion and covering the driver integrated circuit.

13. A plasma display device according to Claim 10, 11 or 12, further comprising:
a heat dissipation pad disposed between the flexible printed circuit and the bent portion.

14. A plasma display device according to claim 13, wherein the heat dissipation pad is disposed between a first surface of the flexible printed circuit and the bent portion, wherein the driver integrated circuit is formed on a second surface of the flexible printed circuit, and wherein the second surface opposes the first surface.

15. A plasma display device according to claim 13 or 14, wherein the heat dissipation pad and the driver integrated circuit are substantially symmetrically positioned with respect to the flexible printed circuit.

16. A plasma display device according to one of Claims 12 to 15, further comprising a thermal grease disposed between the driver integrated circuit and the cover plate.

17. A plasma display device according to any preceding claim, wherein the electrode comprises an address electrode, and the printed circuit board assembly comprises an address buffer board.
